# EUROPEAN PATENT APPLICATION

(11) **EP 1 783 349 A1**
(43) Date of publication of application: **09.05.2007**
(21) Application number: 05757849.4
(22) Date of filing: 05.07.2005
(51) Int. Cl.: F02F 1/00, F02F 3/00, F02F 5/00, C23C 16/27

(54) **PISTON RING, PISTON, CYLINDER AND PISTON PIN HAVING AMORPHOUS AND HARD CARBON FILM**

(30) Priority: 06.07.2004 JP 2004199467
(71) Applicant: TOYOTA JIDOSHA KABUSHIKI KAISHA, Toyota-shi, Aichi-ken 471-8571 (JP); KABUSHIKI KAISHA TOYOTA CHUO KENKYUSHO, Aichi-gun, Aichi-ken, 480-1192 (JP); Teikoku Piston Ring Co., Ltd., Tokyo, 1000005 (JP)
(72) Inventor: MORITANI, Hiroshi, c/o K.K. TOYOTA CHUO KENKYUSHO, Aichi-gun, Aichi 4801192 (JP); HOTTA, Shigeru, c/o K.K. TOYOTA CHUO KENKYUSHO, Aichi-gun, Aichi 4801192 (JP); MORI, Hiroyuki, c/o K.K. TOYOTA CHUO KENKYUSHO, Aichi-gun, Aichi 4801192 (JP); OHMORI, Toshihide, c/o K.K. TOYOTA CHUO KENYUSHO, Aichi-gun, Aichi 4801192 (JP); TOHYAMA, Mamoru, c/o K.K. TOYOTA CHUO KENKYUSHO, Aichi-gun, Aichi 4801192 (JP); SHIMURA, Yoshio, c/o K.K. TOYOTA CHUO KENKYUSHO, Aichi-gun, Aichi 4801192 (JP); TACHIKAWA, Hideo, c/o K.K. TOYOTA CHUO KENKYUSHO, Aichi-gun, Aichi 4801192 (JP); MURAKAMI, Motoichi, c/o TOYOTA JIDOSHA K.K., Toyota-shi, Aichi 4718571 (JP); IWASHITA, Takatsugu, TEIKOKU PISTON RING CO., LTD., Tokyo 1000005 (JP)
(74) Representative: TBK-Patent
(86) International application number: PCT/JP2005/012729
(87) International publication number: WO 2006/004221

(57) **Abstract**

This is to provide a piston ring, a piston, a cylinder and a piston pin, which can realize low friction coefficient without depending on the adsorption or reactions of additives, which are included in lubricating oils, when being employed under wet condition using lubricating oil.

This is to construct a piston ring, a piston, a cylinder and a piston pin, which are employed under wet condition using lubricating oil, so as to be equipped with an amorphous hard carbon film, whose Si content is 1 atomic % or more and 20 atomic % or less and whose surface roughness is Rzjis 0.5 µm or less, respectively.

## Description

### Technical Field

The present invention relates to a piston ring, a piston, a cylinder and a piston pin, which are employed under wet condition using lubricating oil, whose friction coefficient is small, and which is good in terms of the wear resistance.

### Background Art

It is required for sliding members, such as pistons, piston rings, cylinders, and piston pins, which constitute engines, to reduce energy loss resulting from friction as much as possible in view of resource conservation or environmental issues, and the like. Conventionally, the reduction of friction coefficient or the improvement of wear resistance has been intended by forming a film on the sliding surface of sliding member, and by performing a surface treatment, such as a nitriding treatment, to it. Among them, an amorphous hard carbon film, which is called a DLC (diamond-like carbon) film has been expected to be a film which enhances the slidablity of sliding surface (see Patent Literature Nos. 1 and 2, for instance).
Patent Literature No. 1: Japanese Unexamined Patent Publication (KOKAI) Gazette No. 3-240,957; and
Patent Literature No. 2: Japanese Unexamined Patent Publication (KOKAI) Gazette No. 2001-192,864

### Disclosure of Invention

Assignment to be Solved by the Invention

For example, in aforementioned Patent Literature No. 1, an amorphous hard carbon film, which includes silicon (Si), is disclosed. This amorphous hard carbon film, under dry condition free of using lubricating oil, exhibits low friction coefficient. However, under wet condition using lubricating oil, it is difficult for it to reduce friction coefficient. As a factor for this, the influence of a variety of additives, which are included in lubricating oils, is conceivable. Additives in lubricating oils adsorb onto the surface of amorphous hard carbon film and react therewith to form boundary films. Hence, it is believed that friction coefficient is determined by means of boundary films, which are formed during sliding operations. In particular, when using driving-system oils, which assume the high friction for power transmission, as a lubricating oil, it is difficult to reduce friction coefficient.

Meanwhile, in aforementioned Patent Literature No. 2, an attempt to use a lubricating oil, which contains an aromatic compound, is disclosed. Since aromatic compounds are such that the adsorption force onto amorphous hard carbon films is high, they form firm boundary films on the surface of amorphous hard carbon films. That is, by having a firm boundary film formed on the surface of amorphous hard carbon film, it is intended to diminish the solid-contact proportion and reduce friction coefficient. However, in this method, when an additive is altered, by the adsorption and reaction of substance other than the aromatic compound, there is a fear that the reduction of friction coefficient might possibly hindered. Moreover, from the viewpoint of environmental issue, and the like, it is believed as well that reviewing the types of additives and the optimization of amounts would get underway. In this case, it is anticipated that, by the aforementioned method depending on the adsorption and reaction of additive, it would become difficult to reduce friction coefficient.

The present invention is one which has been done in view of such circumstances, and it is an assignment therefor to provide a piston ring, a piston, a cylinder and a piston pin, which can realize low friction coefficient without depending on the adsorption and reaction of additive being included in lubricating oil, when employing them under wet condition using lubricating oil.

Means for Solving the Assignment

(1) A piston ring of the present invention is employed under wet condition using lubricating oil, and comprises: a piston-ring body; and an amorphous hard carbon film being formed on at least a part of the surface of the piston-ring body, the piston ring being characterized in that an Si content of the amorphous hard carbon film is 1 atomic % or more and 20 atomic % or less; and a surface roughness thereof is Rzjis 0.5 µm or less.

Namely, the piston ring of the present invention is equipped with the amorphous hard carbon film whose Si content is 1 atomic % or more and 20 atomic % or less and whose surface roughness is Rzjis 0.5 µm or less. The surface roughness of the amorphous hard carbon film is small considerably. Accordingly, when making the amorphous hard carbon film into a sliding surface, the proportion of boundary friction, which results from solid-solid contact, reduces, but the proportion of lubrication, which results from lubricating oil, increases. Consequently, friction coefficient reduces. Moreover, the amorphous hard carbon film, compared with steel material, is harder and is less likely to wear. Accordingly, even when it contacts slidably with mating member, it can maintain the initial surface roughness. Further, the amorphous hard carbon film includes a predetermined amount of Si. According to the analysis of the present inventors, by means of the fact that it includes Si, silanol (SiOH) is generated on the surface of the amorphous hard carbon film upon contacting slidably therewith. By means of this generation of silanol, even if solids should contact with each other at all, it is believed that the boundary friction reduces sharply. Thus, the piston ring of the present invention exhibits low friction coefficient by means of both actions, the increment of lubrication proportion, which results from lubricating oil, and the reduction of boundary friction. Moreover, it is good in terms of the wear resistance as well.

(2) A piston of the present invention is employed under wet condition using lubricating oil, and comprises: a piston body; and an amorphous carbon hard film being formed on at least a part of the surface of the piston body, the piston being characterized in that an Si content of the amorphous hard carbon film is 1 atomic % or more and 20 atomic % or less; and a surface roughness thereof is Rzjis 0.5 µm or less.

The piston of the present invention is equipped with the same amorphous hard carbon film as that of the above-described piston ring of the present invention. Hence, by making the amorphous hard carbon film into a sliding surface, the piston of the present invention exhibits low friction coefficient by means of both actions, the increment of lubrication proportion, which results from lubricating oil, and the reduction of boundary friction. Moreover, it is good in terms of the wear resistance as well.

(3) A cylinder of the present invention is employed under wet condition using lubricating oil, and comprises: a cylinder body; and an amorphous hard carbon film being formed on the inner peripheral surface of the cylinder body, the cylinder being characterized in that an Si content of the amorphous hard carbon film is 1 atomic % or more and 20 atomic % or less; and a surface roughness thereof is Rzjis 0.5 µm or less.

In the cylinder of the present invention, the amorphous hard carbon film, which is the same as that of the above-described piston ring of the present invention, makes a sliding surface, which contacts slidably with a piston ring or piston. Accordingly, the cylinder of the present invention exhibits low friction coefficient by means of both actions, the increment of lubrication proportion, which results from lubricating oil, and the reduction of boundary friction. Moreover, it is good in terms of the wear resistance as well.

(4) A piston pin of the present invention is employed under wet condition using lubricating oil, and comprises: a piston-pin body; and an amorphous hard carbon film being formed on at least a part of the surface of the piston-pin body, the piston pin being characterized in that an Si content of the amorphous hard carbon film is 1 atomic % or more and 20 atomic % or less; and a surface roughness thereof is Rzjis 0.5 µm or less.

The piston pin of the present invention is equipped with the same amorphous hard carbon film as that of the above-described piston ring of the present invention. - Hence, by making the amorphous hard carbon film into a sliding surface, the piston pin of the present invention exhibits low friction coefficient by means of both actions, the increment of lubrication proportion, which results from lubricating oil, and the reduction of boundary friction. Moreover, it is good in terms of the wear resistance as well.

(5) A first combination of the present invention for sliding member comprises the aforementioned piston ring of the present invention, and the aforementioned piston of the present invention. For example, as the piston of the present invention, when adopting a mode in which the amorphous hard carbon film is formed on a piston-ring groove; and, as the piston ring of the present invention, when adopting a mode in which the amorphous hard carbon film is formed on the two opposite surfaces of piston-ring body, which face in the reciprocative-movement direction of the piston; the amorphous hard carbon films slide on each other in the present combination. Accordingly, the friction-coefficient reduction effect in each of them is demonstrated synergistically, and consequently it is possible to reduce friction coefficient much more.

(6) A second combination of the present invention for sliding member comprises a piston with the aforementioned piston ring of the present invention assembled, and the aforementioned cylinder of the present invention. For example, as the piston ring of the present invention, when adopting a mode in which the amorphous hard carbon film is formed on the outer peripheral surface of piston-ring body; the amorphous hard carbon films slide on each other in the present combination. Accordingly, the friction-coefficient reduction effect in each of them is demonstrated synergistically, and consequently it is possible to reduce friction coefficient much more.

(7) A third combination of the present invention for sliding member comprises the aforementioned piston of the present invention, and the aforementioned cylinder of the present invention. For example, as the piston of the present invention, when adopting a mode in which the amorphous hard carbon film is formed on the piston-skirt portion of piston body; the amorphous hard carbon films slide on each other in the present combination. Accordingly, the friction-coefficient reduction effect in each of them is demonstrated synergistically, and consequently it is possible to reduce friction coefficient much more.

(8) A fourth combination of the present invention for sliding member comprises the aforementioned piston of the present invention, and the aforementioned piston pin of the present invention. For example, as the piston of the present invention, when adopting a mode in which the amorphous hard carbon film is formed on piston holes; and, as the piston pin of the present invention, the amorphous hard carbon film is formed on the outer peripheral surface of piston-pin body; the amorphous hard carbon films slide on each other in the present combination. Accordingly, the friction-coefficient reduction effect in each of them is demonstrated synergistically, and consequently it is possible to reduce friction coefficient much more.

Effect of the Invention

All of the piston ring, piston, cylinder and piston pin of the present invention are equipped with the amorphous hard carbon film whose Si content is 1 atomic % or more and 20 atomic % or less and whose surface roughness is Rzjis 0.5 µm or less. Because the surface roughness of the amorphous hard carbon film is small, the lubrication proportion, which results from lubricating oil, increases. Moreover, since the amorphous hard carbon film includes Si, the boundary friction reduces as well. When using the piston ring, piston, cylinder and piston pin of the present invention so that the amorphous hard carbon film makes a sliding surface, it is possible to realize low friction coefficient without depending on the adsorption and reaction of additive in lubricating oil. Moreover, by combining these suitably to use, it is possible to reduce friction coefficient much more.

### BRIEF DESCRIPTION OF THE DRAWINGS

Fig. 1 is a see-through perspective diagram of a cylinder in which a piston is disposed.

Fig. 2 is a perspective diagram of a top ring which is assembled with the same piston.

Fig. 3 is an outline diagram of a direct-current plasma CVD film-forming apparatus.

Fig. 4 is an outline diagram of a ring-on-block type wear testing machine.

Fig. 5 is a graph for illustrating the relationship between the surface roughness and friction coefficient of DLC-Si film.

Fig. 6 is a graph for illustrating the relationship between the surface roughness of film and the friction coefficient.

Fig. 7 is an outline diagram of a reciprocative sliding testing machine.

Fig. 8 is a graph for illustrating the measurement results on friction coefficient in a reciprocative sliding test (engine oil).

Fig. 9 is a graph for illustrating the measurement results on friction coefficient in a reciprocative sliding test (light oil).

Explanation on Reference Numerals
1: Cylinder
10: Cylinder Body
11: Inner Peripheral Surface
2: Piston
20: Piston Body
21: Piston-ring Groove
22: Piston-skirt Portion
23: Piston-pin Hole
24: Piston Pin
30: Top Ring
31: Second Ring
32: Oil Ring
300: Top-ring Body
301: Outer Peripheral Surface
302: Upper Surface
303: Lower Surface
4: Direct-current Plasma CVD Film-forming Apparatus
40: Chamber
41: Base Stand
42: Gas Inlet Pipe
43: Gas Outlet Pipe
44: Positive Electrode Plate made of Stainless Steel
45: Substrate
5: Ring-on-Block Type Friction Testing Machine
50: Block-shaped Test Piece
51: Ring-shaped Test Piece
52: Oil Bath
500: Film
6: Reciprocative Sliding Testing Machine
60: Cylinder-simulating Member
61: Ring-simulating Member
62: Oil Supply Pipe

### BEST MODE FOR CARRYING OUT THE INVENTION

Hereinafter, the piston ring, piston, cylinder and piston pin of the present invention will be explained in detail. At the beginning, particulars, which are common to the piston ring, piston, cylinder and piston pin of the present invention, will be explained collectively. Next, particulars, which are specific to each of the piston ring, piston, cylinder and piston pin of the present invention, will be explained individually. Moreover, lastly, the combinations of the present invention for sliding member will be explained.

<Common Particulars>

The piston ring, piston, cylinder and piston pin of the present invention are such that all of them are employed in wet condition using lubricating oil. As for a lubricating oil, it is advisable to use engine oils, which have been used usually.

The amorphous hard carbon film, with which the piston ring, piston, cylinder and piston pin of the present invention is equipped, includes carbon (C), hydrogen (H), and Si. The Si content is 1 atomic % or more and 20 atomic % or less. When the Si content is less than 1 atomic %, the reduction effect of boundary friction is small. In order to reduce boundary friction more, it is desirable to make the Si content 5 atomic % or more, and further 6 atomic % or more. Moreover, from the viewpoint of obtaining a practical film-forming rate, it is desirable to make the Si content greater than 5 atomic %. Meanwhile, when the Si content surpasses 20 atomic %, the wear amount of the amorphous hard carbon film has increased. When considering the wear resistance and seizure resistance, it is desirable to make the Si content 9.8 atomic % or less. It is more suitable to make it 9.5 atomic % or less.

Moreover, it is advisable to make the H content 20 atomic % or more and 40 atomic % or less. When the H content is less than 20 atomic %, although the hardness of the amorphous hard carbon film becomes large, the adhesion force and toughness lower. It is suitable to make the H content 25 atomic % or more. On the contrary, when the hydrogen content surpasses 40 atomic %, the hardness of the amorphous hard carbon film becomes small, and accordingly the wear resistance lowers. It is suitable to make the H content 35 atomic % or less.

The surface roughness of the amorphous hard carbon film is Rzjis 0.5 µm or less. When the surface roughness surpasses Rzjis 0.5 µm, it is not possible to expect the increment of lubrication proportion, which results from lubricating oil, and accordingly it is not possible to reduce friction coefficient. Preferably, the surface roughness can be adapted to Rzjis 0.45 µm or less. Further, it is more suitable to adapt it to Rzjis 0.3 µm or less. The calculation method of the surface roughness complies with the method, which is prescribed in JIS B0601 (1994).

The hardness of the amorphous hard carbon film is not one which is limited in particular. For example, when considering the wear resistance, and the like, it can be 15 GPa or more. In the present description, as the hardness of the amorphous hard carbon film, measured values by means of a nano-indenter testing machine ("MTS" produced by KABUSHIKI KAISHA TOYO TECHNICA Corp.) are adopted.

The amorphous hard carbon film can be formed by means of CVD methods or PVD methods, such as plasma CVD methods, ion plating methods and sputtering methods, which have been known publicly already. However, as being represented by sputtering methods, in PVD methods, there is the directivity in film-forming material. Hence, in order to form a film uniformly, it becomes necessary to dispose a plurality of targets within an apparatus, or to rotate a substrate undergoing film forming. As a result, the structure of film-forming apparatus gets complicated, or becomes expensive. Moreover, depending the configuration of substrate, such as the inner peripheral surface of cylinder, there might arise the case where it is difficult to form a film. Meanwhile, plasma CVD methods form a film by means of reaction gas, they can form a film even on those having complicated configuration with ease. Moreover, the structure of film-forming apparatus, too, is simple, and is less expensive. As for plasma CVD methods, high-frequency plasma CVD methods, which utilize high-frequency electric discharge, direct-current plasma CVD methods, which utilize direct-current electric discharge, and the like, are available. In particular, direct-current plasma CVD methods are suitable, because the film-forming apparatus can be constituted of a vacuum furnace and a direct-current electric power source. Moreover, direct-current plasma CVD methods are suitable, because the outer peripheral surface and two opposite surfaces of piston ring can be subjected to film forming simultaneously, and because film forming can be done even with respect to the inner peripheral surface of cylinder easily.

For example, when forming the amorphous hard carbon film by a direct-current plasma CVD method, a substrate is first disposed within a vacuum chamber, and a reaction gas and a carrier gas are introduced into it. Then, a plasma is generated by means of electric discharge, and accordingly the plasma-ionized C, CH, Si, and the like, in the reaction gas can be deposited onto the substrate. As for the reaction gas, it is advisable to use a hydrocarbon gas, such as methane (CH₄) and acetylene (C₂H₂), a silicide gas, such as Si(CH₃)₄ [TMS], SiH₄, SiCl₄ and SiH₂F₄, and a hydrogen gas; and, as for the carrier gas, it is advisable to use an argon gas.

When the piston ring, piston, cylinder and piston pin of the present invention contact slidably with a mating member while adapting the respective amorphous hard carbon films to a sliding surface, silanol is generated on the surface of the amorphous hard carbon films by means of contained Si. The generation of silanol, for instance, can be detected by means of XPS analysis, which utilizes a derivatization method. The derivatization XPS analysis is carried out by the following procedure. First of all, into sulfuric acid, in which a reaction reagent, tridecafluoro-1,1,2,2-tetrahydrooctyl-dimethylchlorosilane, is held, the after-sliding amorphous hard carbon film is immersed for 1 hour. At this time, when silanol is generated, the OH groups of film surface react with the Cl in the reaction agent so that it is dehydrochlorinated. Next, the amorphous hard carbon film is taken out therefrom, and is washed by means of chloroform fully. Thereafter, the silanol amount can be determined quantitatively by finding the F amount by means of XPS analysis.

<Piston Ring>

The piston ring of the present invention comprises a piston-ring body, and the amorphous carbon film, which is formed on at least a part of the surface of the piston-ring body. As for a material quality of the piston-ring body, iron-system materials, such as carbon steel, alloy steel and cast iron, are desirable. The amorphous hard carbon film, in order to reduce the friction coefficient between it and cylinder, can desirably be formed on the outer peripheral surface of the piston-ring body. Moreover, in order to suppress the seizure or wear by means of contacting slidably with piston-ring groove, it can desirably be formed on the two opposite surfaces, which face in the reciprocative-movement direction of piston. By the fact that the seizure or wear of the piston ring is suppressed, anti-wear treatment, such as almite, which has been usually performed onto piston-ring groove, becomes unnecessary, and accordingly the cost can be reduced. Thus, the amorphous hard carbon film can desirably be formed on at least one surface, which is selected from the group consisting of the outer peripheral surface of the piston-ring body and the two opposite surfaces thereof, which face in the reciprocative-movement direction of piston.

In general, the longevity of automobile engine is said to be 300,000 km or more. Accordingly, high durability is required for the piston ring, too. Hence, the thickness of the amorphous hard carbon film, considering wear, and the like, can desirably be adapted to 2 µm or more. When being adapted to 5 µm or more, it is more suitable.

In a sliding environment that a sliding-surface pressure is such a high pressure as 100 MPa or more, the amorphous hard carbon film is likely to come off from the piston-ring body. In order to suppress the come-off of the amorphous hard carbon film, an adhesion force between the piston-ring body and the amorphous hard carbon film can desirably be adapted to 20 N or more (according to a later-described scratching testing method). When being employed in such a sliding environment that a sliding-surface pressure is 1,000 MPa or more, the adhesion force can desirably be adapted to 30 N or more (according to the same scratching testing method). As for the adhesion force between the piston-ring body and the amorphous hard carbon film, a film come-off load by means of ordinary scratching test is adopted. That is, a film is scratched while applying a load to a 120-degree-apex-angle and 0.2-mm-leading-end-radius diamond cone, the load when the film comes off is designated the adhesion force.

From the viewpoint of improving the adhesiveness between the piston-ring body and the amorphous hard carbon film, it is desirable that an irregularity-forming treatment by means of ion bombardment process can be performed onto the surface of the piston-ring body, on which the amorphous hard carbon film is to be formed, in advance. By means of the irregularity-forming treatment, the surface of the piston-ring body turns into an irregular surface, which possesses protrusions whose average height is 10 nm or more and 100 nm or less and whose average width is 300 nm or less, by an irregularity-forming treatment by means of ion bombardment process. By forming the amorphous hard carbon film on this irregular surface, the adhesiveness improves. The protrusions of the formed irregular surface are formed as a semi-sphere shape. The distance from the bottom to apex of this semi-sphere-shaped protrusion is designated the height of the protrusion. Moreover, the horizontal distance, which corresponds to the maximum diameter of the bottom of the semi-sphere-shaped protrusion (the diameter when the bottom-surface configuration of the protrusion is a perfect circle, or the major-axis diameter when the bottom-surface configuration of the protrusion is an oval), is designated the width of the protrusion.

In this case, when the average height is less than 10 nm, no mechanical anchoring effect can be obtained, and accordingly the adhesiveness-improving effect is not sufficient. Meanwhile, when exceeding 100 nm, it becomes difficult to form the amorphous hard carbon film, which is flat and smooth. Note that, when adapting the average height to 20 nm or more and 70 nm or less, the adhesiveness improves more. Moreover, when the average width exceeds 300 nm, no anchoring effect can be obtained, and accordingly the adhesiveness-improving effect is not sufficient. The height and width of the protrusions can be measured by means of scanning electron microscope (SEM), atomic force microscope (AFM), and the like.

Moreover, the areal proportion of the protrusions, which occupy the irregular surface, can be 30 % or more when the area of the irregular surface is taken as 100%. By adapting the areal proportion of the protrusions to 30% or more, it is possible to let the adhesiveness-improving effect of the amorphous hard carbon film demonstrate sufficiently.

The procedure of ion bombardment procedure is as follows. First of all, the piston-ring body is disposed within an enclosed chamber, and gases inside the chamber are evacuated to a predetermined gaseous pressure. The gaseous pressure can desirably be adapted to 0.13 Pa or more and 2, 666 Pa or less. When the gaseous pressure is less than 0.13 Pa, it is not possible to heat the piston-ring body sufficiently. When exceeding 2, 666 Pa, it is not possible to form fine irregularity. Next, a gas for irregularity-forming treatment is introduced. As for this gas for irregularity-forming treatment, it is advisable to utilize a rare gas, which is composed of one member or two members or more being selected from the group consisting of helium, neon, argon, krypton, xenon and radon. Moreover, when adding hydrogen to the rare gas, it is possible to suppress the oxidation of the piston-ring body's surface. Next, ion bombardment is given thereto. As for means for giving ion bombardment thereto, it is advisable to utilize glow electric discharge or ion beam. When carrying out ion bombardment with an electric-discharge voltage of 200-1,000 V and a current of 0.5-3.0 A for 30 -60 minutes, it is possible to form nanometer-order irregularity, which is uniform and fine. Moreover, upon giving ion bombardment thereto, when heating the piston-ring body to such a temperature, at which the hardness of the piston-ring body does not lower (200 °C or more is required), it is possible to form irregularity, which is more uniform and finer.

Moreover, in order to form uniform and fine irregularity, it is desirable to perform a nitriding treatment onto the surface of the piston-ring body prior to the irregularity-forming treatment. As for a method of the nitriding treatment, gas nitriding methods, salt-bath nitriding methods and ion nitriding methods are available. After the nitriding treatment, it is advisable to process the surface thereof by polishing so that the surface roughness becomes Rzjis 0.5 µm or less, and then to give the above-described ion bombardment thereto.

A material quality of piston or cylinder, which makes a mating member of the piston ring of the present invention, can desirably be metals, such as cast iron and aluminum alloys, and ceramic, such as cemented carbide, alumina and silicon nitride. Moreover, as described later, when the mating member, too, is equipped with the amorphous hard carbon film whose Si content is 1 atomic % or more and 20 atomic % or less and whose surface roughness is Rzjis 0.5 µm or less; and the same films are adapted to a sliding surface in both of them, the friction coefficient therebetween can be reduced more so that it is suitable.

<Piston>

The piston of the present invention comprises a piston body, and the amorphous hard carbon film, which is formed on at least a part of the surface of the piston body. As for a material quality of the piston body, aluminum alloys (AC8A, and the like), cast iron, and so forth, are desirable.

The amorphous hard carbon film, in order to reduce the friction coefficient between it and cylinder, can desirably be formed on the piston-skirt portion of the piston body. Moreover, in order to suppress the seizure or wear by means of contacting slidably with piston ring, it can desirably be formed on piston-ring grooves. Further, in order to suppress the seizure or wear by means of contacting slidably with piston pin, it can desirably be formed on piston-pin holes. Thus, the amorphous hard carbon film can desirably be formed on at least one location, which is selected from the group consisting of the piston-ring grooves of said piston body, the piston-skirt portion thereof and the piston-pin holes thereof.

The thickness of the amorphous hard carbon film, considering wear, and the like, can desirably be adapted to 1 µm or more. When being adapted to 3 µm or more, it is more suitable. Note that the piston is such that, comparing with that of piston pin, the sliding-surface pressure is smaller so that it is less like to wear. Accordingly, in the piston, it does not matter that the film thickness is made smaller than that of the piston ring's amorphous hard carbon film.

In a sliding environment that a sliding-surface pressure is such a high pressure as 100 MPa or more, the amorphous hard carbon film is likely to come off from the piston body. In order to suppress the come-off of the amorphous hard carbon film, satisfactory adhesiveness between the piston body and the amorphous hard carbon film becomes necessary. For example, the hardness of aluminum alloy is around 100 Hv, and is smaller than the hardness of steel material. Accordingly, for the above-described scratching testing method, it is difficult to evaluate the adhesiveness. Moreover, since cast iron is a structure which includes graphite, similarly to aluminum alloy, it is difficult for the scratching testing method to evaluate the adhesiveness. Hence, when the piston body is composed of aluminum alloy or cast iron, for instance, the adhesiveness is evaluated by means of Rockwell indentation testing method.

A Rockwell indentation testing method is a method in which a load is applied to a conical diamond penetrator (Rockwell "C"-scale penetrator) by 100-1,500 N and then the adhesiveness is evaluated from the come-off state of film around the indentation thereof. The Rockwell indentation testing method is about to be standardized as DIN in Germany. For example, as set forth in W. Heinke et al., "Evaluation of PVD nitride coatings, using impact, scratch and Rockwell-C adhesion tests, "Thin Solid Films, 270 (1995) pp. 431-438, when no film come-off is appreciable around the indentation (HF1-4), the adhesiveness is evaluated satisfactory. Meanwhile, when film come-off is appreciable (HF5, and 6), the adhesiveness is evaluated defective. Therefore, when the piston body is composed of aluminum alloy or cast iron, the adhesion state between the piston body and the amorphous hard carbon film can desirably be in the states of HF1-4 by the evaluation by means of Rockwell indentation test in which a 1,500-N load is applied thereto.

A material quality of cylinder, piston ring or piston pin, which makes a mating member of the piston of the present invention, can desirably be metals, such as carbon steel, alloy steel, cast iron and aluminum alloys, and ceramic, such as cemented carbide, alumina and silicon nitride. Moreover, when the mating member, too, is equipped with the amorphous hard carbon film whose Si content is 1 atomic % or more and 20 atomic % or less and whose surface roughness is Rzjis 0.5 µm or less; and the same films are adapted to a sliding surface in both of them, the friction coefficient therebetween can be reduced more so that it is suitable.

<Cylinder>

The cylinder of the present invention comprises a cylinder body, and the amorphous hard carbon film, which is formed on the inner peripheral surface of the cylinder body. As for a material quality of the cylinder body, aluminum alloys (A390, AC4C, and the like), cast iron, and so forth, are desirable. The cylinder body can be those which are formed integrally with cylinder block, or can be those which are formed separately as cylinder liner. The size of the cylinder of the present invention is not limited in particular; however, when an aspect ratio [the ratio of length "L" to inside diameter "D" ("L"/"D")] of the cylinder body is 0.8 or more, for instance, the advantages, which result from film forming by means of direct-current plasma CVD method, are great.

The thickness of the amorphous hard carbon film, considering wear, and the like, can desirably be adapted to 2 µm or more. When being adapted to 5 µm or more, it is more suitable.

In a sliding environment that a sliding-surface pressure is such a high pressure as 100 MPa or more, the amorphous hard carbon film is likely to come off from the cylinder body. In order to suppress the come-off of the amorphous hard carbon film, satisfactory adhesiveness between the cylinder body and the amorphous hard carbon film becomes necessary. When the cylinder body is composed of aluminum alloy or cast alloy, for instance, the adhesiveness is evaluated by means of Rockwell indentation testing method as described above. Namely, the adhesion state between the cylinder body and the amorphous hard carbon film can desirably be in the states of HF1-4 by the evaluation by means of Rockwell indentation test in which a 1,500-N load is applied thereto.

A material quality of piston ring or piston, which makes a mating member of the cylinder of the present invention, can desirably be metals, such as carbon steel, alloy steel, cast iron and aluminum alloys, and ceramic, such as cemented carbide, alumina and silicon nitride. Moreover, when the mating member, too, is equipped with the amorphous hard carbon film whose Si content is 1 atomic % or more and 20 atomic % or less and whose surface roughness is Rzjis 0.5 µm or less; and the same films are adapted to a sliding surface in both of them, the friction coefficient therebetween can be reduced more so that it is suitable.

<Piston Pin>

The piston pin of the present invention comprises a piston-pin body, and the amorphous hard carbon film, which is formed on at least a part of the surface of the piston-pin body. As for a material quality of the piston-pin body, iron-system materials, such as carbon steel, alloy steel and cast iron, are desirable. The amorphous hard carbon film, in order to reduce the friction coefficient between it and piston, can desirably be formed on the outer peripheral surface of the piston-pin body.

The thickness of the amorphous hard carbon film, considering wear, and the like, can desirably be adapted to 1 µm or more. When being adapted to 3 µm or more, it is more suitable. In a sliding environment that a sliding-surface pressure is such a high pressure as 50 MPa or more, the amorphous hard carbon film is likely to come off from the piston-pin body. In order to suppress the come-off of the amorphous hard carbon film, an adhesion force between the piston-pin body and the amorphous hard carbon film can desirably be adapted to 10 N or more (according to the above-described scratching testing method). Moreover, when being employed in a sliding environment that a sliding-surface pressure is 100 MPa or more, the adhesion force can desirably be adapted to 20 N or more (according to the same scratching testing method).

A material quality of piston, which makes a mating member of the piston pin of the present invention, can desirably be aluminum alloys, cast iron, and the like. Moreover, when the mating member, too, is equipped with the amorphous hard carbon film whose Si content is 1 atomic % or more and 20 atomic % or less and whose surface roughness is Rzjis 0.5 µm or less; and the same films are adapted to a sliding surface in both of them, the friction coefficient therebetween can be reduced more so that it is suitable.

So far, the embodiment modes of the piston ring, piston, cylinder and piston pin of the present invention have been explained. However, the piston ring, piston, cylinder and piston pin of the present invention are not those which are limited to the aforementioned embodiment modes; but they can be carried out in various modes provided with such changes and modifications that one of ordinary skill in the art can carry out without departing from the spirit or scope of the present invention.

<Combination for Sliding Member>

The above-described piston ring, piston, cylinder and piston pin of the present invention are such that it is desirable to combine each of them appropriately to employ them. For example, the following can be named: a mode in which the piston ring of the present invention is combined with the piston of the present invention; a mode in which this mode is further combined with the cylinder of the present invention; a mode in which a piston, in which the piston ring of the present invention is assembled with a piston-ring groove, is combined with the cylinder of the present invention; a mode in which the piston of the present invention is combined with the cylinder of the present invention; a mode in which the piston pin of the present invention is combined with the piston of the present invention, and the like.

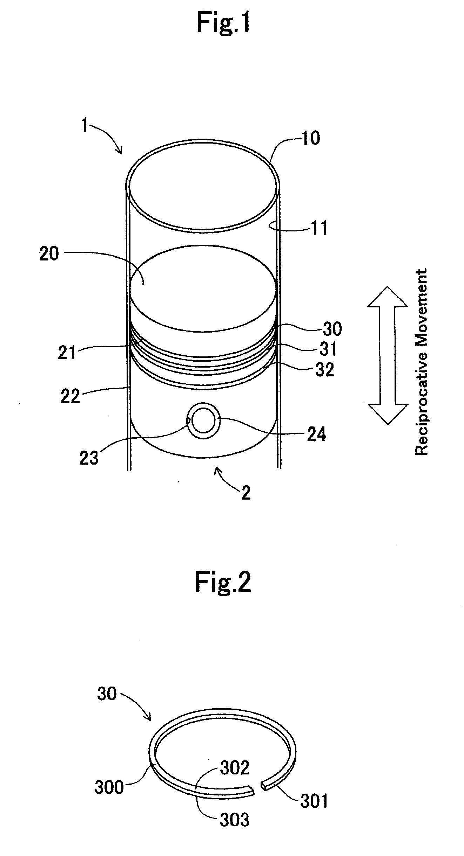

Hereinafter, one of the embodiment modes of the combination of the piston ring, piston, cylinder and piston pin of the present invention will be specified. In Fig. 1, a see-through perspective diagram of a cylinder in which a piston is disposed is illustrated. In Fig. 2, a perspective diagram of a top ring, which is assembled with the same piston, is illustrated.

As illustrated in Fig. 1, a piston 2 is disposed reciprocatably in the up/down direction within a cylinder 1. On an inner peripheral surface 11 of a cylinder body 10, which constitutes the cylinder 1, an amorphous hard carbon film (not shown), whose Si content is 1 atomic % or more and 20 atomic % or less and whose surface roughness is Rzjis 0.5 µm or less, is formed. A piston body 20, which constitutes the piston 2, possesses piston-ring grooves 21, a piston-skirt portion 22, and piston-pin holes 23. Onto the piston-skirt portion 22 and piston-pin holes 23, the same amorphous hard carbon film (not shown) is formed. To the piston-pin holes 23, a piston pin 24 is installed. On an outer peripheral surface of the piston pin 24, the same amorphous hard carbon film (not shown) is formed.

With the piston-ring grooves 21, a top ring 30, a second ring 31, and an oil ring 32 are assembled in this order from above, respectively. The top ring 30, second ring 31 and oil ring 32 are included in the piston ring of the present invention. As illustrated in Fig. 2, a top-ring body 300, which constitutes the top ring 30, possesses an outer peripheral surface 301, an upper surface 302, and a lower surface 303. The top-ring body 300 is included in the piston-ring body of the present invention. Moreover, the upper surface 302 and lower surface 303 are equivalent to the two opposite surfaces, which face in the reciprocative-movement direction of the piston 2. On the outer peripheral surface 301, the same amorphous hard carbon film (not shown) is formed. Moreover, in the same manner as the top ring 30, the same amorphous hard carbon film (not shown) is formed on the outer peripheral surface of the second ring 31 and oil ring 32, too.

The piston 2 reciprocates in the up/down direction within the cylinder 1 in the presence of lubricating oil. On this occasion, the amorphous hard carbon film, which is formed on the inner peripheral surface 11 of the cylinder body 10, the amorphous hard carbon film, which is formed on the respective outer peripheral surfaces of the piston rings 30, 31 and 32, and the amorphous hard carbon film, which is formed on the piston-skirt portion 22, contact slidably with each other. Moreover, the amorphous hard carbon film, which is formed on the piston-pin holes 23, and the amorphous hard carbon film, which is formed on the outer peripheral surface of the piston pin 24, contact slidably with each other. Here, since the surface roughness of the amorphous hard carbon film is as small as Rzjis 0.5 µm or less, the proportion of boundary friction, which results from solid-solid contact, reduces, but the proportion of lubrication, which results from lubricating oil, increases. Moreover, by means of the fact that silanol is generated on the surface of the amorphous hard carbon film upon contacting slidably, the boundary friction reduces sharply. Hence, by means of the both actions, the increment of lubrication proportion and the reduction of boundary friction, the friction coefficients between the piston rings 30, 31 and 32 and the piston 2, and between them and the cylinder 1, can be reduced. Similarly, the friction coefficient between the piston-pin holes 23 and the piston pin 24 can be reduced as well. Moreover, since the amorphous hard carbon film is less likely to be worn off, the piston rings 30, 31 and 32, the piston 2, the piston pin 24, and the cylinder 1 are good in terms of the wear resistance.

So far, an embodiment mode of the combinations of the piston ring, piston, cylinder and piston pin of the present invention has been explained. However, the respective constitutions of the piston ring, piston, cylinder and piston pin of the present invention and the combinations thereof are not limited to the aforementioned embodiment mode. For example, in the aforementioned embodiment mode, the piston rings 30, 31 and 32, the piston 2, the piston pin 24, and the cylinder 1 are constituted of the piston ring, piston, cylinder and piston pin of the present invention, respectively. However, it is advisable to constitute any one of the piston rings 30, 31 and 32, the piston 2, the piston pin 24 and the cylinder 1 by substituting conventional ones for them.

Moreover, in the aforementioned embodiment mode, the amorphous hard carbon film is formed on the outer peripheral surface of the piston rings 30, 31 and 32. However, the amorphous-hard-carbon-film forming location in the piston ring is not one which is limited to the outer peripheral surface. For example, as illustrated in already-appeared Fig. 2, it can be formed on the upper surface 302 or the lower surface 303. Moreover, it is not needed at all to form the amorphous hard carbon film on all of employed piston rings. Of a plurality of piston rings, it is also advisable to form the amorphous carbon film onto some of them alone.

In the aforementioned embodiment mode, the amorphous hard carbon film is formed onto the piston-skirt portion 22 and piston-pin holes 23. However, the amorphous-hard-carbon-film forming location in the piston is not one which is limited to the aforementioned locations. It is advisable as well to form the amorphous hard carbon film onto the piston-ring grooves 21 in addition to the aforementioned locations; or it is advisable as well to form it onto either one of the piston-ring grooves 21, the piston-skirt portion 22 and the piston-pin holes 23.

### EXAMPLES

Based on the aforementioned embodiment mode, various amorphous hard carbon films were formed on the surface of substrate. And, two types of sliding tests were carried out to evaluate the friction characteristics of the respective amorphous hard carbon films. Hereinafter, the respective sliding testes and the evaluation on the friction characteristics will be explained.

(1) Sliding Test by means of Ring-on-Block Type Friction Testing Machine

(a) Formation of Si-containing Amorphous Hard Carbon Film (hereinafter referred to as "DLC-Si film" wherever appropriate)

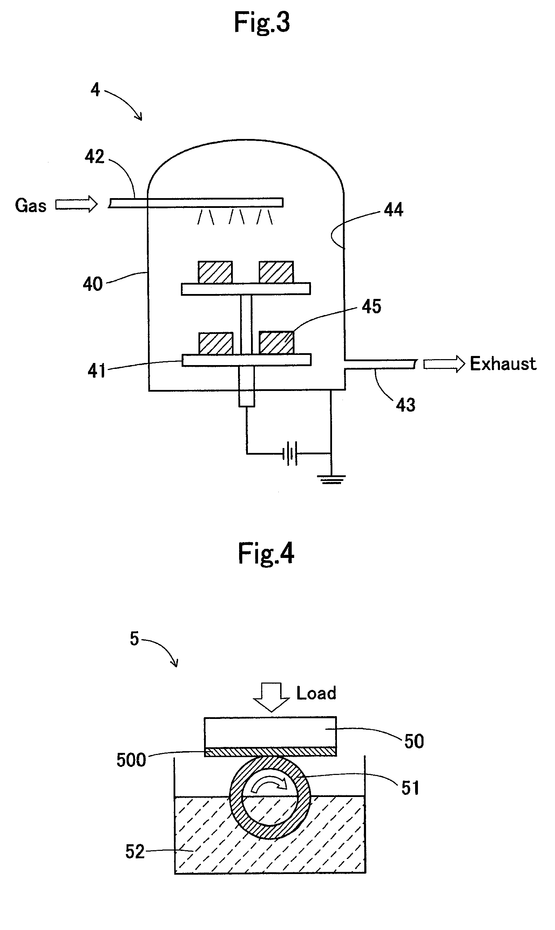

Using a direct-current plasma CVD (PCVD) film-forming apparatus illustrated in Fig. 3, a DLC-Si film was formed on the surface of a substrate. As illustrated in Fig. 3, a direct-current plasma CVD film-forming apparatus 4 is equipped with a chamber 40, which is made of stainless steel, a base stand 41, a gas inlet pipe 42, and a gas outlet pipe 43. The gas inlet pipe 42 is connected with various gas containers (not shown) by way of valves (not shown). The gas outlet pipe 43 is connected with a rotary pump (not shown) and a diffusion pump (not shown) by way of valves.

First of all, substrates 45 were disposed on the base stand 41, which was placed within the chamber 40. The substrates 45 were adapted to block-shaped test pieces (6.3 mm × 15.7 mm × 10.1 mm), which were made of martensite-system stainless steel SUS440C (quenched and tempered product, and 58 HRC). Next, the chamber 40 was sealed, and gases within the chamber 40 were evacuated by means of the rotary pump and diffusion pump, which were connected with the gas outlet pipe 43. A hydrogen gas was introduced into the chamber 40 through the gas inlet pipe 42 in a flow rate of 15 sccm, and the gaseous pressure within the chamber 40 was adapted to about 133 Pa. Thereafter, a direct-current voltage of 200 V was applied between the base stand 41 and a positive electrode plate 44, which was disposed inside the chamber 40 and was made of stainless steel, thereby starting an electric discharge. And, a temperature increment by means of ion bombardment was carried out until the temperatures of the substrates 45 became 500 °C. Next, a 500-sccm nitrogen gas and a 40-sccm hydrogen gas were introduced through the gas inlet pipe 42, and a plasma nitriding treatment was carried out for 1 hour under such conditions that a pressure: about 800 Pa; a voltage : 400 V (an electric current: 1. 5 A) ; and a temperature: 500 °C . When observing the cross-sectional structures of the substrates 45, the nitrided depth was 30 µm.

After the plasma nitriding treatment, a hydrogen gas and an argon gas were introduced through the gas inlet pipe 42 in a flow rate of 30 sccm each; and sputtering was done under such conditions that a pressure: about 533 Pa; a voltage: 300 V (an electric current: 1.6 A); and a temperature: 500 °C , thereby forming fine irregularities on the surfaces of the substrates 45 (irregularity-forming treatment). The width of the protrusions was 60 nm, and the height was 30 nm. Next, a TMS gas was introduced through the gas inlet pipe 42 as a reaction gas in a flow rate of 1 sccm, and a methane gas was introduced in a flow ratio of 100 sccm; further a hydrogen gas and an argon gas were introduced in a flow rate of 30 sccm each; and film forming was done under such conditions that a pressure: about 533 Pa; a voltage: 320 V (an electric current: 1.8 A); and a temperature: 500 °C. The film-forming time was controlled to adapt the film thickness 2.7 µm.

By such a method, three types (Rzjis 0.15 µm, 0.45 µm, and 0.80 µm) of DLC-Si films were formed on the block-shaped test pieces. The thus formed DLC-Si films were numbered DLC-Si-1 through 3, respectively. The composition of these DLC-Si films was Si: 6 atomic %, C: 64 atomic %, and H: 30 atomic %. Moreover, the adhesion force between the DLC-Si films and the substrates was 50 N in all of them. The hardness of the DLC-Si films was 17 GPa in all of them. In the following sliding tests, the DLC-Si films, which were formed on the respective block-shaped test pieces, made sliding surfaces to mating members.

The Si content in the DLC-Si films was analyzed quantitatively by means of electron probe microanalysis (EPMA), X-ray photoelectron spectroscopy (XPS), Auger electron spectroscopy (AES) and Rutherford back scattering spectroscopy (RBS). Moreover, the H content was analyzed quantitatively by means of elastic recoil detection analysis (ERDA). The ERDA is a method in which the surfaces of films are irradiated with a 2-MeV helium ion beam; and hydrogen, which is scattered out of the films, is detected by means of semiconductor detector to measure the hydrogen concentrations in the films.

(b) Sliding Test and Evaluation on Friction Characteristic

Regarding the thus made respective block-shaped test pieces, a sliding test by means of ring-on-block type friction testing machine ("LFW-1" produced by FALEX Corp.) was carried out. In Fig. 4, an outline diagram of a ring-on-block type friction testing machine is illustrated. As illustrated in Fig. 4, a ring-on-block type friction testing machine 5 is constituted of a block-shaped test piece 50, and a ring-shaped test piece 51, which makes a mating member. The block-shaped test piece 50 and ring-shaped test piece 51 are disposed in such a state that a film 500, which is formed on the block-shaped test piece 50, contacts with the ring-shaped test piece 51. The ring-shaped test piece 51 is disposed rotatably within an oil bath 52. In the present sliding test, as the ring-shaped test piece 51, an "S-10" ring-shaped test piece (material quality: carburized SAE4620 steel member; configuration: φ-35 mm and 8.8-mm width; surface roughness: three types, Rzjis 0.37 µm, 0.86 µm and 1.95 µm; and produced by FALEX Corp.) was used. Moreover, in the oil bath 52, an engine oil (Castle Motor Oil "SL5W-30"), which was heated to 80 °C, was used.

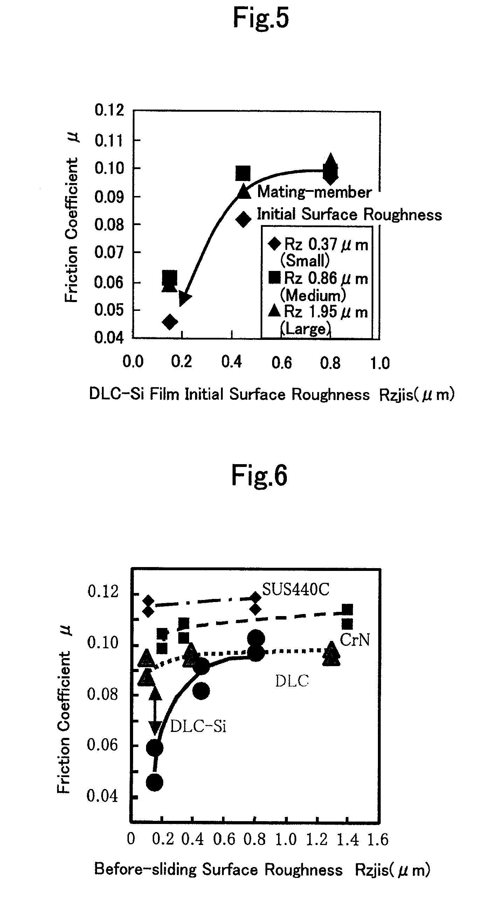

First of all, in a no-load state, the ring-shaped test piece 51 was rotated. Subsequently, after applying a load of 300 N (Hertz-surface pressure: 310 MPa) from above the block-shaped test piece 50 and then the block-shaped test piece 50 and ring-shaped test piece 51 were slid at a sliding speed of 0.3 m/s for 30 minutes, and thereafter the friction coefficient therebetween was measured. Here, the "Hertz-surface pressure" is the maximum value of pressure onto an actual contacting surface into which the elastic deformation at the contact between the block-shaped test piece 50 and the ring-shaped test piece 51 is taken into account. In Fig. 5, the measurement results of the friction coefficients on the respective block-shaped test pieces are illustrated. The horizontal axis of Fig. 5 specifies the surface roughness of the before-sliding DLC-Si film of the respective block-shaped test pieces.

As illustrated in Fig. 5, when the surface roughness of the DLC-Si film was Rzjis 0.80 µm, the friction coefficient was large regardless of the surface roughness of the mating members. However, when it became Rzjis 0.45 µm, the friction coefficient lowered; and further, when it was Rzjis 0.15 µm, the friction coefficient lowered remarkably. Moreover, the smaller the surface roughness of the mating members was, the larger the lowering proportion of the friction coefficient became. Specifically, when the surface roughness of the mating member was Rzjis 0.37 µm, the friction coefficient was lowered by about 50% by adapting the surface roughness of the DLC-Si film from Rzj is 0.45 µm to 0.15 µm. Hence, it is understood that it is possible to reduce the friction coefficient by means of adapting the DLC-Si film whose Si content is 1 atomic % or more and 20 atomic % or less and whose surface roughness is Rzjis 0.5 µm or less to a sliding surface. In particular, it is understood that the reduction effect of friction coefficient was great when the surface roughness was adapted to Rzjis 0.3 µm or less.

Moreover, for comparison, onto the same block-shaped test piece as the one which was provided with the DLC-Si films, a DLC film, which did not contain Si (hereinafter, simply referred to as a "DLC film"), was formed by means of magnetron sputtering (SP) method. The thus provided DLC film was made in three types whose surface roughness differed, and each of them was numbered DLC-1, 2 and 3. Similarly, onto the block-shaped test piece, a CrN film was formed by means of hollow cathode (HCD) method. The thus provided CrN film was made in three types whose surface roughness differed, and each of them was numbered CrN-1, 2 and 3.

Regarding the respective block-shaped test pieces on which the DLC films and the CrN films were formed, and the block-shaped test pieces per se on which no film was formed, a sliding test was carried out by means of the same ring-on-block type friction testing machine as aforementioned. In Fig. 6, the measurement results on the friction coefficients of the respective block-shaped test pieces are illustrated while including the measurement results on those of the block-shaped test pieces, on which the aforementioned DLC-Si films were formed, therein. The horizontal axis of Fig. 6 is the before-sliding surface roughness of the respective block-shaped test pieces. In Fig. 6, the measurement results when the surface roughness of the ring-shaped test piece was Rzjis 0.37 µm, and those when it was Rzjis 1.95 µm are illustrated. That is, in Fig. 6, of the plotted data regarding the identical surface roughness in the respective block-shaped test pieces, those with higher friction coefficient is the results on Rzjis 1.95 µm, and those with lower friction coefficient is the results on Rzjis 0.37 µm. Moreover, in Table 1, the thickness, surface roughness and adhesion force of the films, which were formed on the respective block-shaped test pieces, are shown all together. Note that the block-shaped test pieces (SUS440C) per se, on which no film was formed, are designated SUS440C-1 and 2 depending on the surface-roughness difference.

**[TABLE 1]**

| Sample No. | Film-forming Method | Film Thickness/µm | Surface Roughness Rzjis/µm | Adhesion Force/N |
|---|---|---|---|---|
| DLC-Si-1 | PCVD | 2.7 | 0.15 | 50 |
| DLC-Si-2 | PCVD | 2.7 | 0.45 | 50 |
| DLC-Si-3 | PCVD | 2.7 | 0.80 | 50 |
| DLC-1 | SP | 1.5 | 0.10 | 9 |
| DLC-2 | SP | 1.5 | 0.40 | 7 |
| DLC-3 | SP | 1.5 | 1.30 | 5 |
| CrN-1 | HCD | 2.5 | 0.20 | > 80 |
| CrN-2 | HCD | 2.5 | 0.35 | > 80 |
| CrN-3 | HCD | 2.5 | 1.40 | > 80 |
| SUS440C-1 | - | - | 0.09 | - |
| SUS440C-2 | - | - | 0.80 | - |

As illustrated in Fig. 6, in the DLC films, CrN films and SUS440C, the friction coefficient did not lower even when the surface roughness was made smaller. On the other hand, in the DLC-Si films, as described above, the friction coefficient lowered remarkably by means of making the surface roughness as small as Rzjis 0.5 µm or less. This is believed to result from the fact that the reduction effect of boundary friction was demonstrated in addition to the increment of lubrication proportion which results from lubricating oil.

(2) Sliding Test by means of Reciprocative Sliding Testing Machine

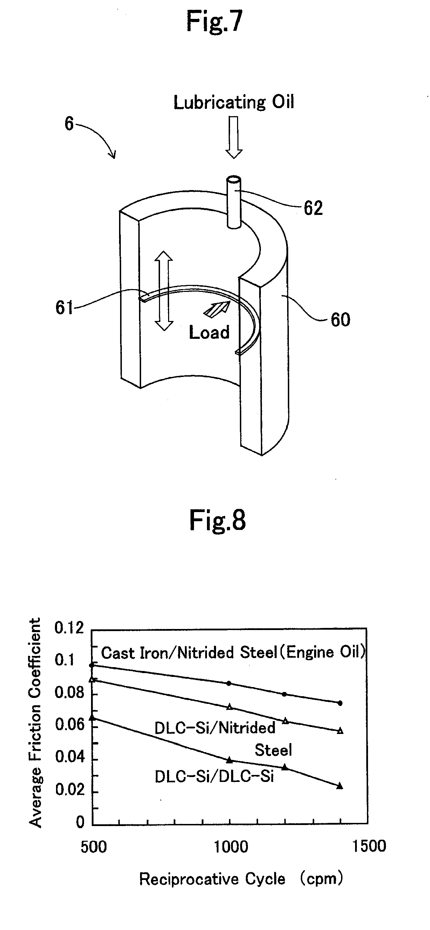

A sliding test was carried out by means of reciprocative sliding testing machine, which simulates the sliding between piston ring and cylinder. In Fig. 7, an outline diagram of a reciprocative sliding test machine is illustrated. As illustrated in Fig. 7, a reciprocative sliding testing machine 6 is constituted of a cylinder-simulating member 60, and a ring-simulating member 61. The material quality of the cylinder-simulating member 60 is cast iron, and the material quality of the ring-simulating member 61 is nitrided steel. The ring-simulating member 61 reciprocates in the up/down direction while contacting slidably with the inner side of the cylinder-simulating member 60. To the sliding part between the cylinder-simulating member 60 and the ring-simulating member 61, a lubricating oil is supplied through an oil supply pipe 62.

The sliding test was carried out by moving the ring-simulating member 61 reciprocatively in such a state that the ring-simulating member 61 was pressed onto the cylinder-simulating member 60 by 100-N load (Hertz-surface pressure: 160 MPa) at a temperature of 90 °C. On this occasion, the supplied lubricating oil was changed so that one of the tests was carried out in the presence of an engine oil (Castle Motor Oil "SL5W-30") and the other one was carried in the presence of a light oil (JIS #2). And, the reciprocating cycle of the ring-simulating member 61 was changed from 500 to 1,000, 1,200 and 1,400 cpm (cycles per minute), and the friction coefficients during each of the reciprocating cycles were measured. The average value of the friction coefficients during each of the reciprocating cycles was adopted as the average friction coefficient.

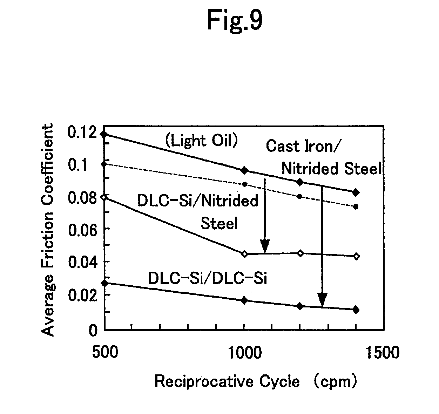

The respective sliding surfaces of the cylinder-simulating member 60 and ring-simulating member 61 in the sliding test were adapted to the following three types of combinations: (i) no film formation [cast iron/nitrided steel]; (ii) DLC-Si film formation onto cylinder-simulating member alone [DLC-Si/nitrided steel]; and (iii) DLC-Si film formation onto both cylinder-simulating member and ring-simulating member [DLC-Si/DLC-Si]. The formation of DLC-Si film was carried out according to the method of aforementioned (1) (a). In Table 2, the surface roughnesses of the sliding surfaces of cylinder-simulating member and ring-simulating member in the aforementioned combinations are specified. Moreover, in Fig. 8, the measurement results of friction coefficients in the presence of the engine oil are illustrated. In Fig. 9, the measurement results of friction coefficients in the presence of the light oil are illustrated.

**[TABLE 2]**

| | Cylinder-simulating Member | Ring-simulating Member |
|---|---|---|
| (i) | 2.04 µm (Cast Iron) | 0.09 µm (Nitrided Steel) |
| (ii) | 0.21 µm (DLC-Si Film) | 0.09 µm (Nitrided Steel) |
| (iii) | 0.21 µm (DLC-Si Film) | 0.11 µm (DLC-Si Film) |

First of all, as illustrated in Fig. 8, the friction coefficients in the presence of the engine oil lowered by forming the DLC-Si film on at least one of the cylinder-simulating member and ring-simulating member. For example, when the DLC-Si film made the sliding surface of the cylinder-simulating member (DLC-Si/nitrided steel), the friction coefficients lowered by about 10% on average. Moreover, when the DLC-Si film made both sliding surfaces of the cylinder-simulating member and ring-simulating member (DLC-Si/DLC-Si), the friction coefficients lowered by about 40% on average. Thus, it is understood the reduction effect of friction coefficient is great when the DLC-Si films slide on each other.

Next, as illustrated in Fig. 9, even in the presence of the light oil, the friction coefficients lowered by forming the DLC-Si film on at least one of the cylinder-simulating member and ring-simulating member. According to the comparison between the cases of being free from film [cast iron/nitrided steel], the friction coefficients rose more when using the light oil than when using the engine oil (designated with the dashed lines in the drawing). However, when the DLC-Si film made the sliding surface of the cylinder-simulating member (DLC-Si/nitrided steel), the friction coefficients lowered remarkably, and accordingly the lowering proportion became about 40% on average. Moreover, when the DLC-Si film made both sliding surfaces of the cylinder-simulating member and ring-simulating member (DLC-Si/DLC-Si), the friction coefficients lowered by as much as about 80% on average. From the foregoing, the friction-reduction effect, which resulted from the DLC-Si film whose Si content was 1 atomic % or more and 20 atomic % or less and whose surface roughness was Rzjis 0.5 µ m or less, was ascertained. Moreover, it was ascertained as well that it is possible to furthermore reduce the friction coefficient by sliding the DLC-Si films on each other.

## Claims

1. A piston ring being employed under wet condition using lubricating oil, and comprising:
a piston-ring body; and an amorphous hard carbon film being formed on at least a part of the surface of the piston-ring body,
the piston ring being **characterized in that** an Si content of the amorphous hard carbon film is 1 atomic % or more and 20 atomic % or less; and a surface roughness thereof is Rzjis 0.5 µm or less.

2. The piston ring set forth in claim 1, wherein said amorphous hard carbon film is formed on at least one surface, which is selected from the group consisting of the outer peripheral surface of said piston-ring body and the two opposite surfaces thereof, which face in the reciprocative-movement direction of piston.

3. The piston ring set forth in claim 1, wherein an adhesion force between said piston-ring body and said amorphous hard carbon film is 20 N or more.

4. The piston ring set forth in claim 1, wherein the surface of the piston-ring body, on which said amorphous hard carbon film to be formed, is turned into an irregular surface, which possesses protrusions whose average height is 10 nm or more and 100 nm or less and whose average width is 300 nm or less, by an irregularity-forming treatment by means of ion bombardment process.

5. The piston ring set forth in claim 1, wherein said amorphous hard carbon film is formed by a direct-current plasma CVD process.

6. A piston being employed under wet condition using lubricating oil, and comprising:
a piston body; and an amorphous carbon hard film being formed on at least a part of the surface of the piston body,
the piston being **characterized in that** an Si content of the amorphous hard carbon film is 1 atomic % or more and 20 atomic % or less; and a surface roughness thereof is Rzjis 0.5 µm or less.

7. The piston set forth in claim 6, wherein said amorphous hard carbon film is formed on at least one location being selected from the group consisting of the piston-ring grooves of said piston body, the piston-skirt portion thereof and the piston-pin holes thereof.

8. The piston set forth in claim 6, wherein said amorphous hard carbon film is formed by a direct-current plasma CVD process.

9. A cylinder being employed under wet condition using lubricating oil, and comprising:
a cylinder body; and an amorphous hard carbon film being formed on the inner peripheral surface of the cylinder body,
the cylinder being **characterized in that** an Si content of the amorphous hard carbon film is 1 atomic % or more and 20 atomic % or less; and a surface roughness thereof is Rzjis 0.5 µm or less.

10. The cylinder set forth in claim 9, wherein said amorphous hard carbon film is formed by a direct-current plasma CVD process.

11. The cylinder set forth in claim 9, wherein an aspect ratio of said cylinder is 0.8 or more.

12. A piston pin being employed under wet condition using lubricating oil, and comprising:
a piston-pin body; and an amorphous hard carbon film being formed on at least a part of the surface of the piston-pin body,
the piston pin being **characterized in that** an Si content of the amorphous hard carbon film is 1 atomic % or more and 20 atomic % or less; and a surface roughness thereof is Rzjis 0.5 µm or less.

13. The piston pin set forth in claim 12, wherein an adhesion force between said piston-pin body and said amorphous hard carbon is 10 N or more.

14. The piston pin set forth in claim 12, wherein said amorphous hard carbon film is formed by a direct-current plasma CVD process.

15. A combination for sliding member comprising: the piston ring set forth in claim 1; and the piston set forth in claim 6.

16. A combination for sliding member comprising: a piston with the piston ring set forth in claim 1 assembled; and the cylinder set forth in claim 9.

17. A combination for sliding member comprising: the piston set forth in claim 6; and the cylinder set forth in claim 9.

18. A combination for sliding member comprising: the piston set forth in claim 6; and the piston pin set forth in claim 12.
